# EUROPEAN PATENT APPLICATION

(11) **EP 4 575 635 A1**
(43) Date of publication of application: **25.06.2025**
(21) Application number: 23219476.1
(22) Date of filing: 21.12.2023
(51) Int. Cl.: G03F 1/66

(54) **STOCKER SYSTEM WITH A STACK OF RETICLE STORAGE PODS WITH PREVENTION OF STORAGE POD HORIZONTAL MOVEMENT**

(71) Applicant: Brooks Automation (Germany) GmbH, 78256 Steißlingen (DE)
(72) Inventor: SCHWETZ, Michael, 8400 Winterthur (CH); SCHMIDT, Alexander, 8203 Schaffhausen (CH)
(74) Representative: Dehns Germany Partnerschaft mbB

(57) **Abstract**

The invention relates to a stocker system (100) for storage of a plurality of reticles (150), especially EUV reticles. The stocker system (100) comprises a plurality of storage pods (111, 112, 113) each adapted to hold one of said reticles (150) in their interior, and to be stacked in a vertical direction (V) one above the other to provide a stack (110), each of the storage pods (111, 112, 113) being provided with two handling members (120) arranged on opposite sides of the storage pod (111, 112, 113) in a first horizontal direction (H1) and each of the handling members (120) being provided with a handling member engagement features (121). The stocker system (100) further comprises two holding structures (200) being provided with a plurality of holding members (210), each of the holding members (210) being provided with a holding member engagement element (211) adapted to engage with a corresponding handling member engagement feature (121), wherein the holding structures (200) are arranged such that, when the holding structures (200) are engaged with the plurality of storage pods (111, 112, 113), movement of the plurality of storage pods (111, 112, 113) in the first horizontal direction is prevented by the holding structures (200) and movement of the plurality of storage pods (111, 112, 113) in a second horizontal direction essentially perpendicular to the first horizontal direction (H1) is prevented by engagement of the handling member engagement features (121) with the holding member engagement elements (211). The invention further relates to storage stocker, a method and a device for retrieving a first storage pod (111) from a stack (110) comprising a plurality of storage pods, a method and a device for retrieving a reticle (150) from a stack (110) comprising a plurality of storage pods and a storage pod (111, 112, 113).

## Description

The present invention relates to a stocker system for storage of reticles, especially EUV reticles, a corresponding storage stocker, a method and a device for retrieving reticles, as well as a storage pod.

### Background

Photolithography processes are widely used as one of the key steps in the manufacture of integrated circuits (ICs) and other semiconductor-related devices and/or structures. However, as the dimensions of features produced by such processes decrease, the importance of photolithography for the production of miniature ICs or other devices and/or structures rises.

In photolithography, a geometric pattern is transferred from a photomask (typically referred to as reticle) onto a substrate, for example a semiconductor wafer, by the use of light, a photosensitive layer and a subsequent etching step. Depending on the desired feature size on the substrate, the feature size of the reticle needs to be adapted as well as the wavelength of the light used for pattern transfer, with consideration of the Rayleigh criterion.

In order to reduce the smallest achievable feature size, it has been proposed to use extreme ultraviolet (EUV) radiation. EUV radiation is electromagnetic radiation having a wavelength within the range of 5-20 nm, for example within the range of 5-10 nm.

Any contamination of the reticle may reduce the imaging performance of the photolithographic process and may in more serious cases require the reticle to be replaced. The reticle is typically expensive and therefore any reduction in the frequency with which it must be cleaned or replaced is advantageous. Furthermore, cleaning and replacement of the reticles are time-consuming and expensive processes, during which the photolithographic process may have to be suspended. The use of uncleaned but impaired reticles is thereby undesirable because of the lower yield.

For EUV applications, particle contamination with particle sizes of less than 10 nm as well as chemical contamination, for example by adsorption of volatile organic compounds, can be relevant.

The reticles used for such EUV applications are therefore typically stored in a storage stocker, referred to in the following simply as a stocker, or more generally, as place of storage, and retrieved when needed in connection with the lithography exposure equipment or other tools. When they are to be used, reticles are transported, usually within a semiconductor fabrication plant, commonly referred to as a fab or FAB, from such a stocker to process tools or inspection tools. Usually, the reticles are stored in a double storage pod (referred to in the following simply as a storage pod) comprising a so-called EUV outer pod (EOP) and an EUV inner pod (EIP) during transportation as well as for storage within the stocker.

Such a double pod is described in further detail in US 2019/0214287 A1 or WO 2018 044 678 A1, for example.

Since the acceptable level of particle contamination is extremely low, friction (which leads to abrasion and thus particle generation) of the reticle against the container as well as friction of container components relative to one another needs to be avoided. Therefore, typical EIPs are designed so as to accommodate one reticle in such a way that it has only very limited possibilities to move therein. They are also equipped with an additional reticle retainer configured and adapted to immobilize the reticle inside the EIP. In order to prevent contamination, the EIP is designed to enable a protective gas to be applied to the reticle.

The EOP is equipped with an actuator adapted to bias the reticle immobilization means of the EIP into a retaining position, thereby immobilizing the reticle inside the EIP when the EOP is attached to the EIP. The EOP also functions to immobilize the typically two components of the EIP, usually referred to as base plate and cover, against one another to prevent friction induced abrasion.

An EIP or similar storage pod can be used to store reticles in a stocker without an EOP. Omitting the outer pod for storage, which is usually made of plastic, improves storage quality by keeping away outgassing materials from the reticle. The movement of the reticle must still be prevented in a stocker without EOP. This is especially relevant in regions with a high risk of earthquakes. While vertical movement of the storage pods is reduced due to the storage pods being stacked on top of each other, movement in the horizontal plane inside the storage stocker is possible and it is necessary to prevent such movement during an earthquake in order to prevent the reticles from being damaged or exposed to dust due to abrasion.

### Summary of the Invention

The present invention addresses these problems by providing a stocker system, a storage stocker, a method and a device for retrieving a reticle pod from a stack of reticle pods and a storage pod according to the respective independent claims. Advantageous embodiments and additional features are provided in the dependent claims and further discussed in the following description.

Due to very strict cleanliness requirements, EUV reticles are typically transported between their place of use, such as a process tool, and a place of storage, usually referred to as a reticle stocker or storage stocker, in double shell containers (double pods, storage pods) comprising a so-called EUV outer pod (EOP) and an EUV inner pod (EIP). These EOPs have dimensions, i.e. sizes and shapes compatible with SEMI E152 standards, to ensure safe and reliable handling with standard fab transportation systems, such as overhead hoist transport (OHT), overhead shuttle (OHS), automated guided vehicles (AGV), person guided vehicle (PGV) and rail guided vehicle (RGV).

Due to risks of earthquakes and the accompanying movement of the storage pods in the storage stocker, the storage pods have to be prevented from movement in the vertical and horizontal direction. Of the two, movement in a horizontal direction potentially poses a greater danger to storage pods and thus reticles contained therein.

Movement in the vertical direction can be prevented by stacking the storage pods on top of one another and/or providing the stocker system with a top and/or bottom plate limiting or preventing any vertical movement of the storage pods in the storage stocker.

The present invention further prevents movement in the horizontal plane by providing holding structures provided with holding members that are provided with holding member engagement members, preferably provided as protrusions or grooves, which can be engaged with corresponding engagement features provided on handling members of the storage pods, referred to as handling member engagement features, preferably provided as grooves or protrusions corresponding to the holding member, which are engageable with one another in a reliable and simple to realise way. Thereby, movement of the storage pods engaged with the holding structures is prevented in two perpendicular directions in the horizontal plane.

In particular, the invention provides a stocker system for storage of a plurality of reticles, especially EUV reticles, comprising a plurality of storage pods, each of which is adapted to hold one of said reticles in their interior, and to be stacked in a vertical direction one above the other to provide a stack. In particular, the stack is formed by storage pods which all have the same outer dimensions. Further each of the storage pods is provided with two handling members arranged on opposite sides of the storage pod in a first horizontal direction and each of the handling members is provided with a handling member engagement feature. The handling member engagement feature is preferably provided as a groove or protrusion. It is pointed out that the storage pod can also be provided with more than two handling members, wherein each of the handling members is provided with handling member engagement features. For example, in a case where the storage pod has a rectangular shape, four handling members can be provided, one on each side of the storage pod, such that a handling robot can grip the storage pod at the handling member without the necessity of a rotation of the storage pod, which significantly reduces handling times. Such a handling robot is preferably provided with at least one handling element, also known as an end effector, for handling, i.e. transporting, storage pods. Further, each of the handling members can also be provided with more than one handling member engagement feature, in particular handling members can be provided with a mix of grooves and protrusion as handling member engagement features.

The stocker system further comprises two holding structures being provided with a plurality of holding members, wherein each of the holding members is provided with a holding member engagement element adapted to engage with a corresponding handling member engagement feature. The holding member engagement element is thus preferably provided as a protrusion or groove complementary to the groove or protrusion provided as the handling member engagement feature. Again, the stocker system can be provided with more than two holding structures, for example three holding structures. The number of holding member engagement elements complementary to the handling member engagement features is at least equal to the number of the handling member engagement features on the storage pods. The number of holding members depends on the number of storage pods to be secured by a pair of holding structures and can vary from 3 to 5 to 10. Further, if a top and/or a bottom plate are to be provided on the bottom and top of the stack, a holding member for each of the top and/or bottom plate has to be provided on each of the holding structures. The holding structures are arranged in the stocker system such that, when the holding structures are engaged with the plurality of storage pods, movement of the plurality of storage pods in the first horizontal direction is prevented by the storage holding structures and movement of the plurality of storage pods in a second horizontal direction essentially perpendicular to the first horizontal direction is prevented by engagement of the handling member engagement features with the holding member engagement elements. Further, the holding members and holding member engagement elements are arranged on the holding structure such that they point toward the storage pods.

Thereby, during an earthquake, movement in the vertical direction is prevented by the storage pods being stacked on top of each other and further by a top and/or bottom plate. Additionally, movement of the storage pods in the horizontal plane, i.e. in either of the first and second horizontal direction, is prevented by the holding structures and the engagement of the handling member engagement features with the holding member engagement elements.

If the handling member engagement features and holding member engagement elements are provided as grooves or protrusion they preferably have the form of a half circle, a rectangle, a triangle or a polygon. Accordingly, the shape of the protrusion and grooves can be flexibly chosen and thus be adapted to the specific circumstances and manufacturing process.

Preferably, the holding members are arranged along the holding structures in the vertical direction distanced apart by a distance equal to a thickness of the storage pods in the vertical direction. Thereby, it can be ensured that the storage pods are all stacked on top of each other, while the handling member engagement features of each of the storage pods is engaged with the complementary holding member engagement element of the holding member and thus movement of the storage pod in the horizontal plane is efficiently prevented, while the space requirement of the stocker system is minimized.

According to a preferred embodiment, each storage pod comprises a base plate and a cover, wherein alignment features configured and adapted to mechanically align adjacent storage pods in a stacked configuration are provided on the base plate and the cover. In particular, the base plate is provided with grooves or pins as alignment features, and the cover is provided with corresponding pins or grooves as alignment features and grooves and pins are provided for interacting with corresponding pins or groves provided on adjacent storage pods. Such alignment features ensure a precise and exact alignment and positioning of storage pods in the stack. For example, adjacent storage pods stacked one above the other can respectively be provided with interacting pins, preferably dome shaped pins, often referred to as kinematic coupling pins in the technical field, and correspondingly shaped recesses. Hereby, alignment and positioning of storage pods and at the same time a safeguard against horizontal movement of adjacent storage pods with respect to one another can be achieved. This is advantageous to ensure effective handling through handling robots.

Advantageously, each storage pod can be provided with a latch mechanism for securing base plate and cover to one another. Such a latch mechanism can comprise a number of latches, and ensure a tight connection, in particular a gas tight connection, between base plate and cover, these components usually being made of a metal material. Especially, such a latch mechanism is adapted to prevent relative movement of base plate and cover relative to one another in a locked state, thereby preventing abrasion. Also, the latch mechanism can be adapted to immobilise a reticle within a storage pod relative to the storage pod, which also minimises abrasion and contamination effects.

Advantageously, the handling members are arranged on either the base plate or the cover plate. Thereby, stacking of the storage pods and simultaneous engagement of the storage pods with the handling structures can be ensured, while the height of the holding members can be reduced as different engagement positions do not need to be accounted for.

The present invention also provides a storage stocker comprising such a stocker system and a storage entity adapted to store the stocker system. Such a storage stocker typically also includes an Equipment Front End Module (EFEM) including at least one load port, and a storage area, in which the stocker system is located. The storage stocker is part of a semiconductor fab.

Advantageously, the storage stocker is provided with a securing mechanism, for example a clamping mechanism or a spring mechanism, to physically secure the individual storage pods to one another and/or to the storage entity in which the stack is stored. Hereby, an efficient safety measure against damage to individual storage pods or reticles housed therein due to earthquakes is provided. For example, a spring mechanism comprising at least one spring can be provided to continuously provide a downward force acting on the top of the stack. For example, the spring can be adapted to push down on a plate positioned above the uppermost storage pod. This plate can, for example, be provided with handles, for example shaped in a similar manner to handling members that can be provided on the storage pods, so that the handles and thus the plate can be lifted to access the top storage pod. The plate could be provided with alignment features (e.g., pins and/or holes) located on its lower side facing the storage pods, in order to engage corresponding alignment features such as holes and/or pins of the uppermost storage pod. A permanently empty storage pod in the top position could also be used instead of such a plate. The robot would work against the spring mechanism when it lifts the stack. A spring mechanism comprising at least one spring could also be provided underneath the stack, for example acting against a bottom plate under the stack of storage pods. Instead of or in addition to such a spring mechanism, a cam or other type of clamp mechanism could exert a force against a top plate, an uppermost storage pod, a bottom plate or a lowermost storage pod. Such a cam or clamp would then be actively released when access is desired.

Such a securing mechanism can be utilised in addition to gravity effects, which also assist in securing stacked storage pods stacked to one another.

The present invention also provides a method of retrieving a first storage pod from a stack comprising of a plurality of storage pods stacked in a vertical direction in a stocker system. In the stack, a second storage pod is arranged adjacent and vertically above the first storage pod and a third storage pod is arranged adjacent and vertically below the first storage pod. Each storage pod is provided with two handling members arranged on opposite sides of the storage pod in a first horizontal direction, each of the handling members being provided with a handling member engagement feature and each of the storage pods is prevented from movement in a first horizontal direction by two holding structures, and in a second horizontal direction, essentially perpendicular to the first horizontal direction, by engagement of the handling member engagement features with holding member engagement elements provided on the holding structures. In the method the second storage pod is lifted in a vertical direction by a first distance. In particular, the first distance has to be large enough to enable lifting of the first storage pod such that the first storage pod can be disengaged from the holding member engagement elements. Thereby, it can be ensured that there is enough space between the second storage pod and the first storage pod such that the first storage pod can be lifted by a second distance that is at least equal to a height, in the vertical direction, necessary to disengage the handling member engagement feature of the first storage pod from the holding member engagement elements. Subsequently or simultaneously, the first storage pod is lifted in a vertical direction by the second distance. Thereby, the first storage pod is disengaged from the holding structure and can freely be moved in the second horizontal direction. Then, the first storage pod is retracted in the second horizontal direction and the second storage pod is lowered down in a vertical direction onto the third storage pod that was initially arranged adjacent and vertically below the first storage pod.

Thereby, the first storage pod can be disengaged from the holding member engagement elements of the holding members preventing movement in the second horizontal direction and thereby retrieved from the stack.

It is understood that the first distance has to be at least the same as the second distance, i.e. the distance necessary to disengage a storage pod from the engagement with the holding structure engagement elements. For example, in a case where the holding structure engagement elements and handling member engagement features have the same height and are arranged centrally in the vertical direction, the first distance is equal to the height of the holding structure engagement elements and/or handling member engagement features. However, it is preferable for the holding structure engagement elements to have a height in the vertical direction that is larger than the height in the vertical direction of the handling member engagement features. The height of the handling member engagement features in the vertical direction is set by the height of the handling members and thus can be considered to be small. Thus, in a case where an earthquake results in vertical movement of the storage pods, disengagement of the storage pods from the holding structure is possible. To prevent this, the holding structure engagement elements preferably have larger height than the handling member engagement features. In this case, the first distance is at least equal to a sum of half of a height of the holding member engagement elements and half a height of the handling member engagement features. If the storage pods are further provided with alignment features, the height has to at least be equal to the height of the alignment features in the vertical direction. Thereby, the first storage pod can not only be disengaged from the handling member, but also from alignment features of the adjacent pods and then moved in the second horizontal direction to be retracted from or inserted into the stack. Further, the first and second distance also have to take into account the height of alignment features provided on the storage pods, i.e. the first distance has to be large enough to be able to disengage the first storage pod from the holding member engagement element and the alignment features of the adjacent second and third storage pods.

Further, the present invention also provides a method of storing a first storage pod in a stack comprising a plurality of storage pods stacked in a vertical direction in a stocker system. In the stack a second storage pod is arranged adjacent and above a third storage pod. Each of the storage pod is provided with two handling members arranged on opposite sides of the storage pod in a first horizontal direction, each of the handling members is provided with a handling member engagement feature, and each of the storage pods in the stack is prevented from movement in a first horizontal direction by two holding structures, and in a second horizontal direction essentially perpendicular to the first horizontal direction by engagement of the handling member engagement features with holding member engagement elements provided on the holding structures. In the method, the second storage is lifted, in the vertical direction, off the third storage pod by a third distance, the third distance being greater than the height of the first storage pod. Then the first storage pod is inserted, in the second horizontal direction into a gap formed between the second storage pod and the third storage pod. The gap is formed by lifting the second storage pod off the third storage pod and is large enough so that the first storage pod, in particularly also with alignment features, fits into the gap. Afterwards, the first storage pod is lowered, in the vertical direction, onto the third storage pod, and subsequently, the second storage pod is lowered, in the vertical direction, onto the first storage pod.

The invention also provides a device for retrieving a first storage pod from and inserting the first storage pod into a stack comprising a plurality of storage pods stacked in a vertical direction in a stocker system Each storage pod is provided with two handling members arranged on opposite sides of the storage pod in a first horizontal direction, each of the handling members being provided with a handling member engagement feature, wherein each of the storage pods is prevented from movement in a first horizontal direction by two holding structures, and in a second horizontal direction, essentially perpendicular to the first horizontal direction, by engagement of the handling member engagement features with holding member engagement elements provided on the holding structures. The device comprises a first handling element for handling the first storage pod, and a second handling element adapted to handle a second storage pod, the first storage pod being arranged or inserted adjacent and vertically below the third storage pod within the stack of storage pods, wherein the first handling element and the second element are adapted to be individually displaceable in the second horizontal direction and jointly or individually displaceable in a vertical direction such that the second storage pod can be lifted off the first storage pod or the third storage pod and the first storage pod can be lifted off or lowered onto a third storage pod, the first storage pod being arranged or inserted adjacent and vertically above the third storage pod within the stack of storage pods, the first storage pod can be retrieved from or inserted into the stack of storage pods, and the second storage pod can be placed on the third storage pod or first storage pod. The device is further adapted to perform the aforementioned method of retrieving a first storage pod from a stack of a plurality of storage pods and/or the method of storing a first storage pod into a stack of a plurality of storage pods.

Advantageously, the first handling element and the second handling element are adapted to have a vertical distance from one another that is greater than a vertical distance of respective handling members provided on the first and second storage pods when the second storage pod is stacked on the first storage pod, with which the handling elements interact in order to lift the second storage pod off the first storage pod and the first storage pod off the third storage pod.

Expediently, the vertical distance between the handling members is provided to be fixed. This simplifies the construction of the drive of the handling members in vertical direction, leading to enhanced reliability.

Advantageously, the vertical distance between the first handling element and the second handling element is greater than a sum of the height of the handling member and the height of an alignment feature of the first storage pod or the second storage pod. Thereby, the distance between the first and second storage pod when the second storage pod is lifted is great enough to also disengage the first and second storage pods that are engaged by the alignment members and thus could otherwise not be moved in a horizontal direction with respect to one another.

Expediently, the first handling element and the second handling element are each provided to comprise two horizontally extending arms adapted to interact with handling members provided on opposite sides of the first and second reticle pod respectively.

Advantageously, the device comprises a drive adapted to individually displace the first handling mechanism and the second handling mechanism in a horizontal direction, in particular the second horizontal direction, and to jointly or individually displace the first handling mechanism and the second handling mechanism in a vertical direction.

The present invention further provides a method of retrieving a reticle that is stored in a first storage pod from the first storage pod in a stack comprising a plurality of storage pods stacked in a vertical direction in a stocker system, wherein each storage pod comprises a base plate and a cover and is provided with two handling members arranged on opposite sides of the storage pod in a first horizontal direction, each of the handling members is provided with a handling member engagement feature, and each of the storage pods is prevented from movement in a first horizontal direction by two holding structures, and in a second horizontal direction essentially perpendicular to the first horizontal direction by engagement of the handling member engagement features with holding member engagement elements provided on the holding structures. According to the method the cover of the first storage pod is lifted in the vertical direction by a fourth distance, wherein the fourth distance is greater than a height of the reticle. In particular, the fourth distance has to be large enough to allow for the reticle to be disengaged from the bottom plate and retrieved without being damaged. By lifting the cover of the first storage pod, also the second storage pod arranged adjacent and above the first storage pod, and all other storage pods arranged above, are lifted. Next, the reticle is lifted in the vertical direction by a fifth distance, wherein the fifth distance is at least equal to the height, in the vertical direction, necessary to disengage the reticle from the base plate. To lift the reticle, an active end effector can, for example, be used. The active end effector is inserted in the second horizontal direction, lowered down to be on the same level as the reticle, which is stored in pocket formed by the baseplate. The active end effector then grips the reticle and lifts the reticle by the fifth distance. In this case, the fourth distance, by which the cover is lifted, has to be large enough to allow the active and effector to be inserted into the gap between the cover and the base plate and lift the reticle by the fourth distance, i.e. the fourth distance has to be larger than a sum of the fifth distance and the height of the active end effector in the vertical direction. Afterwards, the reticle is retracted in the second horizontal direction from the first storage pod, and the cover of the first storage pod is lowered in the vertical direction onto the base plate of the first storage pod.

The present invention further relates to a method of storing a reticle in a first storage pod in a stack comprising a plurality of storage pods stacked in a vertical direction in a stocker system. Each storage pod comprises a base plate and a cover and is provided with two handling members arranged on opposite sides of the storage pod in a first horizontal direction. Each of the handling members is provided with a handling member engagement feature, and each of the storage pods in the stack is prevented from movement in a first horizontal direction by two holding structures, and in a second horizontal direction essentially perpendicular to the first horizontal direction by engagement of the handling member engagement features with holding member engagement elements provided on the holding structures. In the method, the cover is lifted, in the vertical direction, off the first storage pod by a sixth distance, the sixth distance being greater than a height of the reticle. In particular, the sixth system is the same as the fourth distance. Afterward, the reticle is placed, in the vertical direction, the reticle onto the base plate of the first storage pod. If, similarly to the previously described method, an active end effector is used, the active end effector is inserted, in the second horizontal direction, into the gap formed between the cover and the base plate of the first storage pod, the reticle is lowered into the pocket of the base plate in which the reticle is to be stored and released by the active end effector. Then, the active end effector is lifted without the reticle, retrieved, in the second horizontal direction, from the gap. Subsequently, the cover is lowered, in the vertical direction, onto the base plate of the first storage pod.

Thereby, a reticle can be stored in a storage pod in a stack with a plurality of storage pods.

The invention further provides a device for retrieving a reticle from and storing a reticle in a first storage pod in a stack comprising a plurality of storage pods stacked in a vertical direction in a stocker system. Each storage pod comprises a base plate and a cover and is provided with two handling members arranged on opposite sides of the storage pod in a first horizontal direction and each of the handling members being provided with a handling member engagement feature and being prevented from movement in a first horizontal direction by two holding structures, and in a second horizontal direction essentially perpendicular to the first horizontal direction by engagement of the handling member engagement features with holding member engagement elements provided on the holding structures. The device comprises a third handling element for handling the cover of the first storage pod, and a fourth handling element adapted to handle the reticle. The reticle is arranged or to be placed in the first storage pod, wherein the third handling element and the fourth handling element are adapted to be individually displaceable in the second horizontal direction and jointly or individually displaceable in the vertical direction such that the cover of the first storage pod can be lifted off and lowered onto the base plate of the first storage pod and the reticle can be lifted off and lowered onto the base plate of the first storage pod, the reticle can be retrieved from and placed in the first storage pod of the stack of storage pods. Subsequently, the cover of the first storage pod can be placed back on the base plate of the first storage pod. The device is further adapted to perform the aforementioned method of retrieving a reticle from a first storage pod in a stack comprising a plurality of storage pods and/or the aforementioned method of storing a reticle in a first storage pod in a stack comprising a plurality of storage pods.

Aspects which need to be considered when developing such an improved storage concept include that it is highly undesirable to change the way the reticles are provided to the photolithographic process equipment, this typically being the most complicated and costly part of a semiconductor production facility.

Be it noted that all the method steps discussed herein can advantageously be carried out in an automated manner, for example by one or more robotic components.

The invention also provides a storage pod configured and adapted to store a reticle within a stocker, comprising a base plate and a cover, the storage pod is provided with alignment features configured and adapted to enable mechanical alignment with an adjacent storage pod in case of a stacked configuration. Preferably, the storage pod is provided with a latch mechanism is for holding together the base plate and the cover in a releasable manner and adjacent storage pods in a stacked configuration are essentially identical to one another. Further, the storage pod is provided with two handling members arranged on opposite sides of the storage pod in a horizontal direction, i.e. the first horizontal direction, and each of the handling members includes handling member engagement feature, preferably provided as a groove or protrusion. As mentioned above, the storage pod can also be provided with more than two handling members and each handling member can be provided with more than one handling member engagement feature.

Thereby, the storage pod can be engaged with holding members of holding structures of a stocker system to prevent movement in the horizontal plane.

The invention thus provides a two-part storage pod having complementary alignment features (e.g., pins and holes) on its top and bottom surfaces such that pods can be stacked one on top of one another, thus facilitating automation of handling.

### Brief description of the drawings

Advantages and further aspects of the invention will now be discussed further with reference to the appended drawings. Herein,
Figure 1 shows a perspective view of a preferred embodiment of the stocker system according to the present invention,
Figure 2 shows a top view of a preferred embodiment of the stocker system according to the present invention,
Figure 3 shows a side view of a preferred embodiment of the stocker system according to the present invention,
Figures 4a and 4b show a side view and top view of a storage pod according to a preferred embodiment of the present invention, and
Figures 5a to 5e show side views of the stocker system according to a preferred embodiment of the present invention at different stages of retrieving a first storage pod from the stocker system.
Figures 6a to 6e show side views of the stocker system according to a preferred embodiment of the present invention at different stages of retrieving a reticle from the first storage pod in the stocker system.

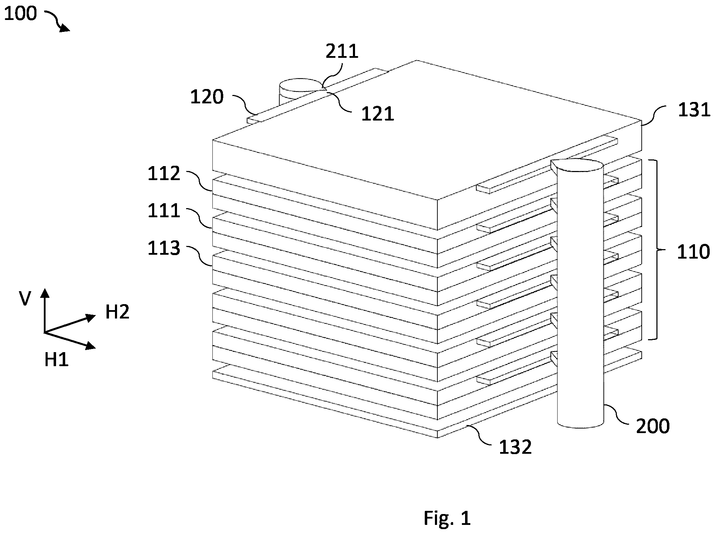

In Figure 1, a perspective view of a preferred embodiment of the stocker system 100 is shown. The stocker system 100 includes five storage pods 111, 112, 113 stacked on top of each other in a vertical direction V to form a stack 110. The stack 110 is positioned between a top plate 131 and a bottom plate 132, whereby movement of the stack 110 in the vertical direction V is prevented.

Each of the storage pods 111, 112, 113 of the stack 110 is provided with two handling members 120 that comprise a handling member engagement feature. In the embodiments shown in the Figures, the handling member engagement features are provided in the form of grooves 121. Further, two holding structures 200 are provided in the stocker system 100, which are arranged on opposite sides of the storage pods 111, 112, 113 in a first horizontal direction H1.

By providing the holding structures 200 on each side of the storage pods 111, 112, 113 in the first horizontal direction H1, movement of the stack 110 of storage pods 111, 112, 113 can be prevented in the first horizontal direction H1. Further, the holding structures 200 are each provided with holding members 210 each of which is provided with a holding member engagement element 211. In the embodiments shown in the Figures, the holding member engagement elements are provided as protrusions 211, which are complementary to the grooves 121. According to embodiments not explicitly shown in the Figures, it is also conceived to provide the handling member engagement features as protrusions, and the holding member engagement elements as grooves complementary thereto.

By engaging the grooves 121 of the handling members 120 of the storage pods 111, 112, 113 with corresponding protrusions 211 of the holding members 210 of the holding structure 200, movement of the stack 110 in a second horizontal direction H2 perpendicular to the first horizontal direction H1 is also prevented and thus, the stack 110 of storage pods 111, 112, 113 cannot move in the horizontal plane.

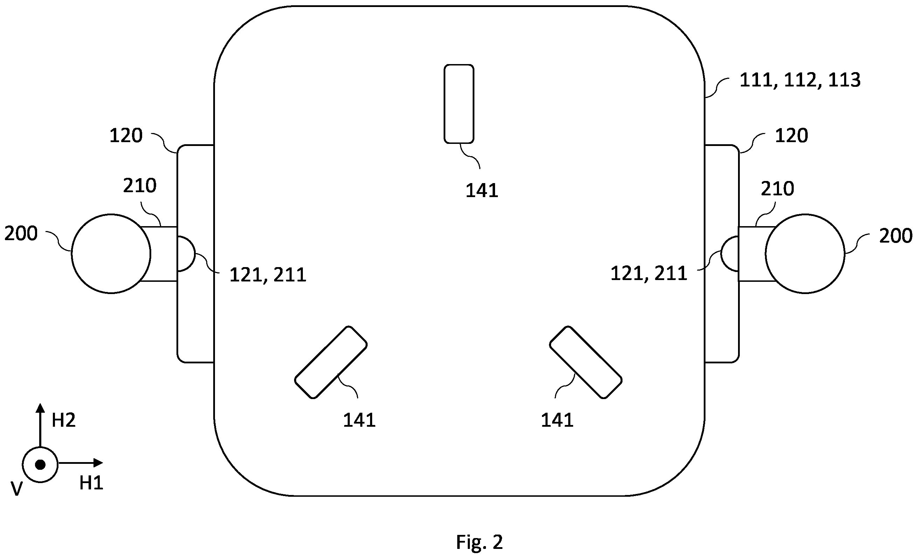

Figure 2 shows a top view of a preferred embodiment of the stocker system 100. In Figure 2, alignment features 141 provided on the top surface of the storage pods 111, 112, 113 are, as mentioned, exemplarily shown as grooves 141.

Further, the storage pod 111, 112, 113 is engaged with the holding structure 200 via the protrusions 211 and the grooves 121.

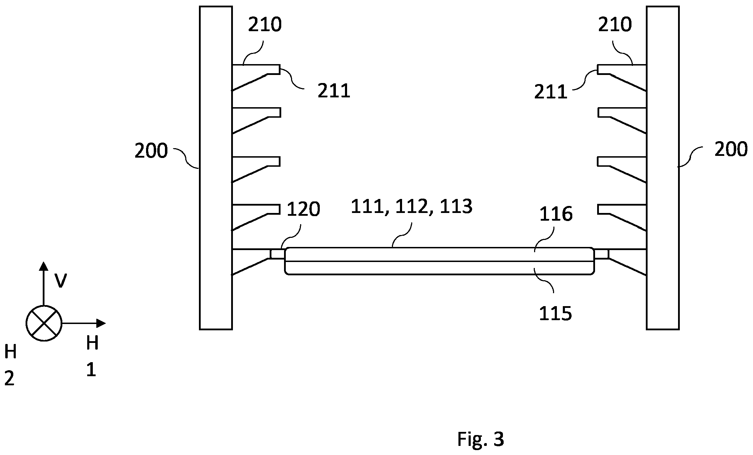

Figure 3 shows a side view of a preferred embodiment of the stocker system 100. Herein, only one storage pod 111, 112, 113 is exemplarily shown. The two holding structures 200 are arranged on opposite sides of the storage pod 111, 112, 113 in the first horizontal direction H1 and are each provided with five holding members 210, wherein each of the holding members 210 is provided with a protrusion 211 with which a groove 121 of the holding member 120 can be engaged to prevent movement of the storage pod 111, 112, 113 in the second horizontal direction H2. To disengage the storage pod 111, 112, 113 from the holding member 210, the storage pod 111, 112, 113 has to be lifted in the vertical direction V by a first distance.

Further, the storage pod 111, 1112, 113 comprises a base plate 115 and a cover 116 and is provided with two handling members 120 provided on opposite sides in the first horizontal direction H1 on the cover 116.

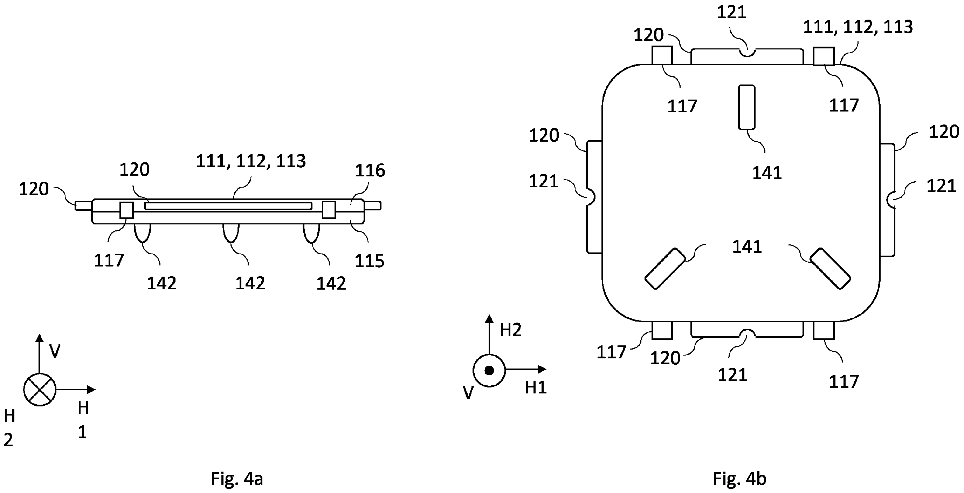

Figures 4a and 4b schematically show a side view and top view of a storage pod 111, 112, 113 according to a preferred embodiment of the invention.

In Figure 4a, it can be seen that the storage pod 111, 112, 113 comprises a base plate 115 and a cover 116 and is shown in a closed state in which the storage pod 111, 112, 113 usually houses a reticle 150. On the lower side of the base plate 115, alignment features in the form of pins 142 (three are shown) are provided. Further, as can be seen in Figure 4b, the cover 116 is provided, on its upper side, with alignment features in the form of grooves 141 complementary to the pins 142. It is pointed out that the pins 142 could also be provided on the cover 116 and the complementary grooves 141 could be provided on the base plate 115. Adjacent storage pods 111, 112, 113 can be physical or mechanical aligned in a stacked configuration by the complementary alignment features 141, 142. Grooves 141 and pins 142 are formed and positioned to mate with one another such that an exact alignment of the storage pods 111, 112, 113 is provided when they are stacked one above the other. Such an exact alignment is a precondition for effective robot handling by a handling robot. Advantageously, the grooves 141 are provided as elongated holes or slots.

Further, base plate 115 and cover 116 are held together by a latch mechanism 117, of which two latches 117 provided on the front side of the storage pod 111, 112, 113 are visible in Figures 4a and 4b. Two further latches 117, which are not visible in Figure 4a, are provided on the rear side of the storage pod 111, 112, 113 (see Figure 4b). Alternatively, there may only be two latch mechanism at diagonally opposite corners of the storage pod. Typically, the latch mechanism 117 can be provided to define two states, a locked state, in which base plate 115 and cover 116 are tightly closed, providing a protected interior therebetween and an unlocked state, in which base plate 115 and cover 116 can be separated from one another, for example in order to load or unload reticles 150. Typically, the latches 117 remain in the locked positions, until they are actively changed to unlocked states for accessing the reticle 150.

The latch mechanism 117 serves to hold baseplate 115 and cover 116 together during storage in the reticle stocker and transportation to and from a transfer station (e.g., a storage pod opener station), in which the reticle 150 is transferred from an EIP of a double pod to a storage pod 111, 112, 113 or vice versa. Be it noted that the latch mechanism 117 may hold base plate 115 and cover 116 together in an airtight manner to provide a separate atmosphere in the inside of a storage pod 111, 112, 113, thus minimising contamination from the outside. Also, in case of for example a positive gas pressure in the inside of the storage pod 111, 112, 113, it is not necessary for the latch mechanism 117 to hold base plate 115 and cover 116 together in an airtight manner in order to minimise contamination inside the storage pod 111, 112, 113. Advantageously, in the locked position, the latch mechanism 117 serves to prevent any movement of the base plate 115 and the cover 116 relative to one another, thereby minimising or avoiding any abrasion effects during storage of reticles 150, which can lead to unacceptable contamination.

The storage pods 111, 112, 113 are provided with a mechanism for fixing a reticle 150 inside the storage pod 111, 112, 113, when the storage pod 111, 112, 113 is in its closed position, which further minimises potential contamination due to abrasion effects caused by movement of the reticle 150 in the storage pod 111, 112, 113. Advantageously, the latch mechanism 117 is adapted to fix the base plate 115 and the cover 116 relative to one another, as mentioned above, and the reticle 150 relative to the storage pod 111, 112, 113.

On each side of the storage pods 111, 112, 113, there is provided a handling member 120, such as a handling flange or a handle. Providing handling members 120 on each side enables a handling robot to grip the storage pod 111, 112, 113 from any side, without the necessity of rotating the storage pod 111, 112, 113. In the embodiment shown, the side handling members 120 are provided on the cover 116. It is also conceivable to provide them on the base plate 115, or for example two on opposite sides of the base plate 115, and two on different opposite sides of the cover 116, whereby individual handling of the base plate 115 or the cover 116 by the handling robot is rendered possible or at least simplified.

The dimensions of the storage pods 111, 112, 113, i.e. their size and shape, are preferably fully compatible with existing fully automated EUV pod cleaning equipment.

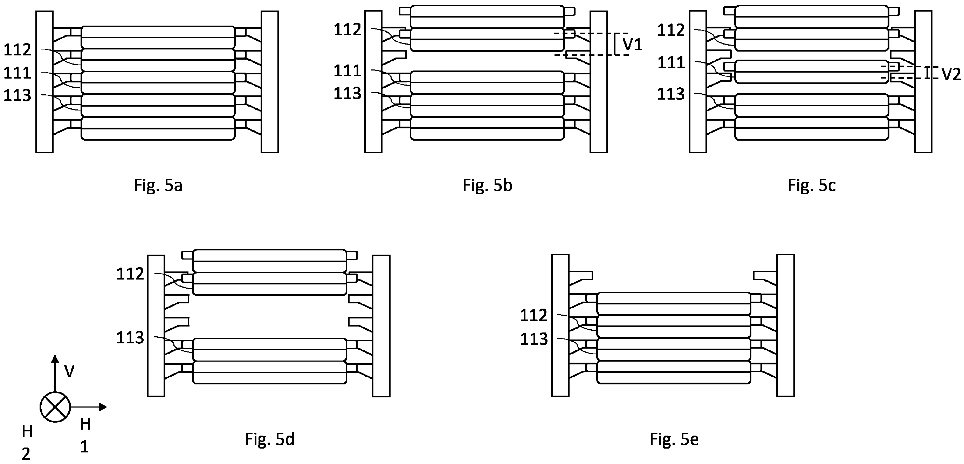

Figures 5a to 5e show side views of the stocker system 100 according to a preferred embodiment at different stages of retrieving a first storage pod 111 from the stocker system 100.

In Figure 5a, the storage pods 111, 112, 113 are stacked on top of each other to form the stack 110 and are engaged with the holding structure 200 via grooves 121 and protrusions 211 to prevent movement in the horizontal plane, i.e. in the first horizontal direction H1 and the second horizontal direction H2.

A device for retrieving a first storage pod 111 is then used to lift the second storage pod 112, which is arranged adjacent and above the first storage pod 111 in a vertical direction V, by a first distance V1, as is shown in Figure 5b. The first distance V1 has to at least be such that it is possible to lift the first storage pod 111 by a distance that allows the first storage pod 111 to be disengaged from the holding member 210. Further, the distance V1 has to also be large enough to allow for disengagement of the alignment features 141, 142 of the first storage pod 111 and the second storage pod 112 after the first storage pod 111 is lifted by the distance necessary to disengage the first storage pod 111 from the holding member 210 of the holding structure 200.

Simultaneously or subsequently, as shown in Figure 5c, the first storage pod 111 is lifted, in the vertical direction V, by a second distance V2, that is necessary to disengage the first storage pod 111 from the respective holding member 210 with which the first storage pod 111 was engaged. Further, the second distance V2 should be small enough to not erroneously engage the first storage pod 111 with the holding member 210 arranged above the holding member 210 with which the first storage pod 111 was engaged, i.e. the holding member 210 with which the second storage pod 112 was engaged. Additionally, the second distance V2 has to be large enough to disengage the alignment features 141, 142 of the first storage pod 111 and the third storage pod 113. Thereby the first storage pod 111 is disengaged from the alignment feature 141, 142 of the third storage pod 113 and the holding member 210 of the holding structure 200 and not being lifted so far as to reengage with the alignment features 141, 142 of the second storage pod 112.

Then, the first storage pod 111 is retracted in the second horizontal direction H2, as is shown in Figure 5d.

As a final step, the second storage pod 112 is lowered onto the third storage pod 113.

The device for retrieving the first storage pod 111 from the stack 110 of storage pods 111, 112, 113 in particular can include a first and second handling element for handling the first and second storage pods 111, 112, respectively. In particular, the first and the second handling element are each provided to comprise two horizontally extending arms adapted to interact with handling members 120 provided on opposite sides of the first and second storage pod 111, 112 in the first horizontal direction H1, respectively. The first and second handling elements are further spaced apart from one another by a first vertical distance that is greater than a second distance V2 of respective handling members 120 provided on the first and second storage pods 111, 112 when the second storage pod 112 is stacked on the first storage pod 111, with which the handling elements 120 interact in order to lift the second storage pod 112 off the first storage pod 111 and the first storage pod 111 off the third storage pod 113. In particular, the first and second handling element are spaced apart from one another by a distance that is at least equal to the height, in the vertical direction V, of the alignment features 141, 142.

Similarly, the first storage pod 111 can be stored in the stack 110 by lifting the second storage pod 112 (i.e. in Figure 5e) in the vertical direction by a third vertical distance (see Figure 5d). The third vertical distance is in particular greater than the sum of the second vertical distance V2 and the height of the first storage pod 111.

Then, the first storage pod 111 is inserted in the gap formed between the second storage pod 112 and the third storage pod 113 (see Figure 5c) and lowered onto the third storage pod 113 (see Figure 5b). Subsequently or simultaneously, the second storage pod 112 is lowered onto the first storage pod 111.

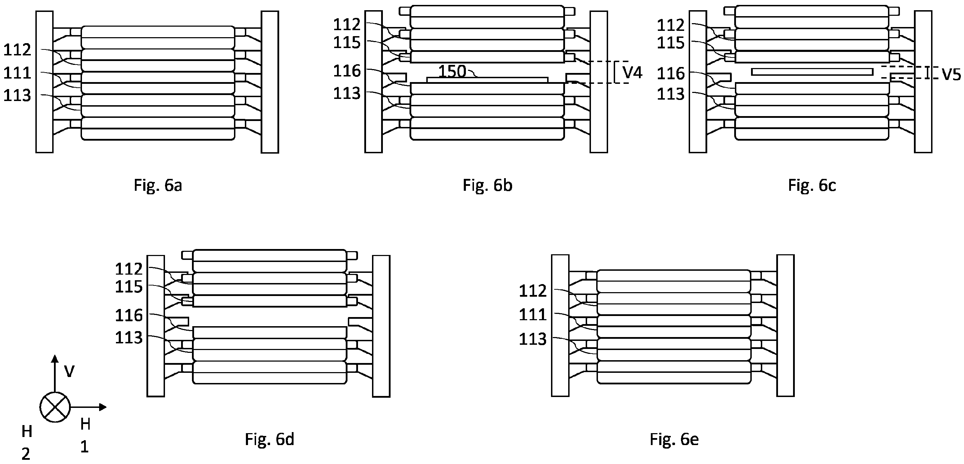

Figures 6a to 6e show side views of the stocker system 100 according to a preferred embodiment at different stages of retrieving a reticle 150 from the first storage pod 111 in the stocker system 100.

In Figure 6a, the storage pods 111, 112, 113 are stacked on top of each other to form the stack 110 and are engaged with the holding structure 200 via grooves 121 and protrusions 211 to prevent movement in the horizontal plane, i.e. in the first horizontal direction H1 and the second horizontal direction H2. Further, each of the storage pods 111, 112, 113 comprises a base plate 115 and a cover 116, wherein the cover 116 can be lifted off the base plate 115.

A device for retrieving a reticle from the first storage pod 111 is then used to lift the cover 116 of the first storage pod 111 in a vertical direction V, by a fourth distance V4, as is shown in Figure 6b. The fourth distance V4 has to be greater than the height of the reticle 150 such that it is possible to lift the reticle 150 by a distance that allows the reticle 150 to be disengaged from the base plate 115 of the first storage pod 111.

Subsequently, as shown in Figure 6c, the reticle 150 is lifted, in the vertical direction, by a fifth distance V5, that is necessary to disengage the reticle 150 from the base plate of the first storage pod 111 in which the reticle 150 is stored. Further, the fifth distance V5 should be small enough to not erroneously destroy the reticle 150 by hitting the cover 116.

Then, the reticle 150 is retracted in the second horizontal direction, from the storage pod, as can be seen in Figure 6d and subsequently, the cover 116 is lowered back onto the base plate 115, as is shown in Figure 6e.

Similarly, the reticle 150 can be stored in the first storage pod 111 by performing the method in the opposite direction.

Starting in Figure 6e, the cover 116 of the first storage pod 111 is lifted of the base plate 115 by a sixth distance, wherein the sixth distance is in particular the same as the fourth distance V4 , as shown in Figure 6d.

Then, the reticle 150 is inserted, in the second horizontal direction H2, into the gap formed between the cover 116 and the base plate 115 (see Figure 6c) and lowered onto the base plate 115 and subsequently, the cover 116 is lowered back onto the base plate 115 (see Figure 6a).

## Claims

1. Stocker system (100) for storage of a plurality of reticles (150), especially EUV reticles, comprising:
- a plurality of storage pods (111, 112, 113) each adapted to hold one of said reticles (150) in their interior, and to be stacked in a vertical direction (V) one above the other to provide a stack (110), each of the storage pods (111, 112, 113) being provided with two handling members (120) arranged on opposite sides of the storage pod (111, 112, 113) in a first horizontal direction (H1) and each of the handling members (120) being provided with a handling member engagement feature (121),
- two holding structures (200) provided with a plurality of holding members (210), each of the holding members (210) being provided with a holding member engagement element (211) adapted to engage with a corresponding handling member engagement feature (121),
- wherein the holding structures (200) are arranged such that, when the holding structures (200) are engaged with the plurality of storage pods (111, 112, 113), movement of the plurality of storage pods (111, 112, 113) in the first horizontal direction is prevented by the holding structures (200) and movement of the plurality of storage pods (111, 112, 113) in a second horizontal direction essentially perpendicular to the first horizontal direction is prevented by engagement of the handling member engagement features (121) with the holding member engagement elements (211).

2. Stocker system (100) according to claim 1, wherein the handling member engagement features (121) are provided as grooves and the holding member engagement elements (211) are provided as protrusions or vice versa.

3. Stocker system (100) according to any of claims 1 or 2, wherein the holding members (210) are arranged in the vertical direction (V) distanced apart by a distance equal to a thickness of the storage pods (111, 112, 113) in the vertical direction (V).

4. Stocker system (100) according to any one of the preceding claims, wherein each storage pod comprises a base plate (115) and a cover (116), wherein alignment features (141, 142) configured and adapted to mechanically align adjacent storage pods (111, 112, 113) in the stack (110) are provided on the base plate (115) and the cover (116).

5. Stocker system (100) according to claim 4, wherein the handling members (120) are arranged on either the base plate (115) or the cover (116).

6. Storage stocker comprising a stocker system (100) according to any one of the preceding claims and a storage entity adapted to store the stocker system.

7. Storage stocker according to claim 6, comprising a securing mechanism adapted to physically secure individual storage pods (111, 112, 113) to one another and/or to the storage entity.

8. Method of retrieving a first storage pod (111) from a stack (110) comprising a plurality of storage pods (111, 112, 113) stacked in a vertical direction (V) in a stocker system (100), wherein each storage pod (111, 112, 113) is provided with two handling members (120) arranged on opposite sides of the storage pod (111, 112, 113) in a first horizontal direction (H1), each of the handling members (120) is provided with a handling member engagement feature (121), and each of the storage pods (111, 112, 113) is prevented from movement in a first horizontal direction (H1) by two holding structures (200), and in a second horizontal direction (H2) essentially perpendicular to the first horizontal direction (H1) by engagement of the handling member engagement features (121) with holding member engagement elements (211) provided on the holding structures (200), comprising the following steps:
- lifting, in the vertical direction (V), a second storage pod (112) arranged adjacent and vertically above the first storage pod (111) by a first distance (V1),
- lifting, in the vertical direction (V), the first storage pod (111) by a second distance (V2), wherein the second distance (V2) is at least equal to the height, in the vertical direction (V), necessary to disengage the handling member engagement feature (121) of the first storage pod (111) from the holding member engagement elements (211),
- retracting, in the second horizontal direction (H2), the first storage pod (111), and
- lowering, in the vertical direction (V), the second storage pod (112) onto a third storage pod (113) arranged adjacent and vertically below the first storage pod (111).

9. Method of storing a first storage pod (111) in a stack (110) comprising a plurality of storage pods (112, 113) stacked in a vertical direction (V) in a stocker system (100), wherein each storage pod (111, 112, 113) is provided with two handling members (120) arranged on opposite sides of the storage pod (111, 112, 113) in a first horizontal direction (H1), each of the handling members (120) is provided with a handling member engagement feature (121), and each of the storage pods (111, 112, 113) in the stack (110) is prevented from movement in a first horizontal direction (H1) by two holding structures (200), and in a second horizontal direction (H2) essentially perpendicular to the first horizontal direction (H1) by engagement of the handling member engagement features (121) with holding member engagement elements (211) provided on the holding structures (200), comprising the following steps:
- lifting, in the vertical direction (V), a second storage pod (112) arranged adjacent and vertically above a third storage pod (113) by a third distance, the third distance being greater than the height of the first storage pod (111),
- inserting, in the second horizontal direction (H2), the first storage pod (111) into a gap formed between the second storage pod (112) and the third storage pod (113),
- lowering, in the vertical direction (V), the first storage pod (111) onto the third storage pod (113), and
- lowering, in the vertical direction (V), the second storage pod (112) onto the first storage pod (111).

10. Device for retrieving a first storage pod (111) from and storing a first storage pod (111) in a stack (110) comprising a plurality of storage pods (111, 112, 113) stacked in a vertical direction (V) in a stocker system (100), each storage pod (111, 112, 113) being provided with two handling members (120) arranged on opposite sides of the storage pod (111, 112, 113) in a first horizontal direction (H1) and each of the handling members (120) being provided with a handling member engagement feature (121) and being prevented from movement in a first horizontal direction (H1) by two holding structures (200), and in a second horizontal direction (H2) essentially perpendicular to the first horizontal direction (H1) by engagement of the handling member engagement features (121) with holding member engagement elements (211) provided on the holding structures (200), comprising
- a first handling element for handling the first storage pod (111), and a second handling element adapted to handle a second storage pod (112), the first storage pod (111) being arranged or inserted adjacent and vertically below the second storage pod (112) within the stack (110) of storage pods (111, 112, 113), wherein the first handling element and the second handling element are adapted to be individually displaceable in a second horizontal direction (H2) and jointly or individually displaceable in a vertical direction (V) such that the second storage pod (112) can be lifted off or lowered onto the first storage pod (111) and the first storage pod (111) can be lifted off or lowered onto a third storage pod (113), the first storage pod (111) being arranged or inserted adjacent and vertically above the third storage pod (113) within the stack (110) of storage pods (111, 112, 113), the first storage pod (111) can be retrieved form or inserted into the stack (110) of storage pods (111, 112, 113), and the second storage pod (112) can be placed on or lifted of the third storage pod (113), the device being configured to perform the method of any of claims 8 and/or 9.

11. Method of retrieving a reticle (150) from a first storage pod (111) in a stack (110) comprising a plurality of storage pods (111, 112, 113) stacked in a vertical direction (V) in a stocker system (100), wherein each storage pod (111, 112, 113) comprises a base plate (115) and a cover (116) and is provided with two handling members (120) arranged on opposite sides of the storage pod (111, 112, 113) in a first horizontal direction (H1), each of the handling members (120) is provided with a handling member engagement feature (121), and each of the storage pods (111, 112, 113) is prevented from movement in a first horizontal direction (H1) by two holding structures (200), and in a second horizontal direction (H2) essentially perpendicular to the first horizontal direction (H1) by engagement of the handling member engagement features (121) with holding member engagement elements (211) provided on the holding structures (200), comprising the following steps:
- lifting, in the vertical direction (V), the cover (116) of the first storage pod (111) by a fourth distance (V4), the fourth distance (V4) being greater than a height of the reticle (150),
- lifting, in the vertical direction (V), the reticle (150) by a fifth distance (V5), the fifth distance (V5) being at least equal to the height, in the vertical direction (V), necessary to disengage the reticle (150) from the base plate (115),
- retracting, in the second horizontal direction (H2), the reticle (150) from the first storage pod (111), and
- lowering, in the vertical direction (V), the cover (116) of the first storage pod (111) onto the base plate (115) of the first storage pod (111).

12. Method of storing a reticle (150) in a first storage pod (111) in a stack (110) comprising a plurality of storage pods (111, 112, 113) stacked in a vertical direction (V) in a stocker system (100), wherein each storage pod (111, 112, 113) comprises a base plate (115) and a cover (116) and is provided with two handling members (120) arranged on opposite sides of the storage pod (111, 112, 113) in a first horizontal direction (H1), each of the handling members (120) is provided with a handling member engagement feature (121), and each of the storage pods (111, 112, 113) in the stack (110) is prevented from movement in a first horizontal direction (H1) by two holding structures (200), and in a second horizontal direction (H2) essentially perpendicular to the first horizontal direction (H1) by engagement of the handling member engagement features (121) with holding member engagement elements (211) provided on the holding structures (200), comprising the following steps:
- lifting, in the vertical direction (V), the cover (116) off the first storage pod (111) by a sixth distance, the sixth distance being greater than a height of the reticle (150),
- placing, in the vertical direction (V), the reticle (150) onto the base plate (115) of the first storage pod (111), and
- lowering, in the vertical direction (V), the cover (116) onto the base plate (115) of the first storage pod (111).

13. Device for retrieving a reticle (150) from a first storage pod (111) and placing the reticle (150) into a first storage pod (111) in a stack (110) comprising a plurality of storage pods (111, 112, 113) stacked in a vertical direction (V) in a stocker system (100), each storage pod (111, 112, 113) comprising a base plate (115) and a cover (116) and being provided with two handling members (120) arranged on opposite sides of the storage pod (111, 112, 113) in a first horizontal direction (H1) and each of the handling members (120) being provided with a handling member engagement feature (121) and being prevented from movement in a first horizontal direction (H1) by two holding structures (200), and in a second horizontal direction (H2) essentially perpendicular to the first horizontal direction (H1) by engagement of the handling member engagement features (121) with holding member engagement elements (211) provided on the holding structures (200), comprising
- a third handling element for handling the cover (116) of the first storage pod (111), and a fourth handling element adapted to handle the reticle (150), the reticle (150) being arranged or to be placed in the first storage pod (111), wherein the third handling element and the fourth handling element are adapted to be individually displaceable in the second horizontal direction (H2) and jointly or individually displaceable in the vertical direction (V) such that the cover (116) of the first storage pod (111) can be lifted off the base plate (115) of the first storage pod (111) and the reticle (150) can be lifted off the base plate (115) of the first storage pod (111) or placed onto the base plate (115) of the first storage pod (111), the reticle (150) can be retrieved from or placed into the first storage pod (111) of the stack (110) of storage pods (111, 112, 113), and the cover (116) of the first storage pod (111) can be placed back on the base plate (115) of the first storage pod (111),
the device being configured to perform the method of any of claims 11 and/or 12.

14. Storage pod (111, 112, 113) configured and adapted to store a reticle (150) within a stocker system (100), comprising a base plate (115) and a cover (116), the storage pod (111, 112, 113) being provided with alignment features (141, 142) configured and adapted to enable mechanical alignment with an adjacent storage pod (111, 112, 113) in a stacked configuration of storage pods (111, 112, 113) and provided with two handling members (120) arranged on opposite sides of the storage pod (111, 112, 113) in a horizontal direction, and each of the handling members (120) including a handling member engagement feature (121), preferably provided as a groove or protrusion.

## Amended claims

### Amended claims in accordance with Rule 137(2) EPC.

1. Stocker system (100) for storage of a plurality of reticles (150), especially EUV reticles, comprising:
- a plurality of storage pods (111, 112, 113) each adapted to hold one of said reticles (150) in its interior, comprising a base plate (115) and a cover (116), wherein alignment features (141, 142) configured and adapted to mechanically align adjacent storage pods (111, 112, 113) in the stack (110) are provided on the base plate (115) and the cover (116), and to be stacked in a vertical direction (V) one above the other to provide a stack (110), each of the storage pods (111, 112, 113) being provided with two handling members (120) arranged on opposite sides of the storage pod (111, 112, 113) in a first horizontal direction (H1) and each of the handling members (120) being provided with a handling member engagement feature (121),
- two holding structures (200) provided with a plurality of holding members (210), each of the holding members (210) being provided with a holding member engagement element (211) adapted to engage with a corresponding handling member engagement feature (121),
**characterized in that**
- wherein the holding structures (200) are arranged such that, when the holding structures (200) are engaged with the plurality of storage pods (111, 112, 113), movement of the plurality of storage pods (111, 112, 113) in the first horizontal direction is prevented by the holding structures (200) and movement of the plurality of storage pods (111, 112, 113) in a second horizontal direction essentially perpendicular to the first horizontal direction is prevented by engagement of the handling member engagement features (121) with the holding member engagement elements (211).

2. Stocker system (100) according to claim 1, wherein the handling member engagement features (121) are provided as grooves and the holding member engagement elements (211) are provided as protrusions or vice versa.

3. Stocker system (100) according to any of claims 1 or 2, wherein the holding members (210) are arranged in the vertical direction (V) distanced apart by a distance equal to a thickness of the storage pods (111, 112, 113) in the vertical direction (V).

4. Stocker system (100) according any of the preceding claims, wherein the handling members (120) are arranged on either the base plate (115) or the cover (116).

5. Storage stocker comprising a stocker system (100) according to any one of the preceding claims and a storage entity adapted to store the stocker system.

6. Storage stocker according to claim 5, comprising a securing mechanism adapted to physically secure individual storage pods (111, 112, 113) to one another and/or to the storage entity.

7. Method of retrieving a first storage pod (111) from a stack (110) comprising a plurality of storage pods (111, 112, 113) stacked in a vertical direction (V) in a stocker system (100), wherein each storage pod (111, 112, 113) is adapted to hold one reticle (150) in its interior, comprises a base plate (115) and a cover (116), wherein alignment features (141, 142) configured and adapted to mechanically align adjacent storage pods (111, 112, 113) in the stack (110) are provided on the base plate (115) and the cover (116), and is provided with two handling members (120) arranged on opposite sides of the storage pod (111, 112, 113) in a first horizontal direction (H1), each of the handling members (120) is provided with a handling member engagement feature (121), and each of the storage pods (111, 112, 113) is prevented from movement in a first horizontal direction (H1) by two holding structures (200), and in a second horizontal direction (H2) essentially perpendicular to the first horizontal direction (H1) by engagement of the handling member engagement features (121) with holding member engagement elements (211) provided on the holding structures (200), comprising the following steps:
- lifting, in the vertical direction (V), a second storage pod (112) arranged adjacent and vertically above the first storage pod (111) by a first distance (V1), wherein the first distance (V1) is at least equal to a height, in the vertical direction (V), necessary to disengage the first storage pod (111) from the holding member engagement elements (211) and the alignment features (141, 142) of the second storage pod (112) and a third storage pod (113) arranged adjacent and vertically below the first storage pod (111),
- lifting, in the vertical direction (V), the first storage pod (111) by a second distance (V2), wherein the second distance (V2) is at least equal to the height, in the vertical direction (V), necessary to disengage the handling member engagement feature (121) of the first storage pod (111) from the holding member engagement elements (211) and the alignment features (141, 142) of the first storage pod (111) and the third storage pod (113),
- retracting, in the second horizontal direction (H2), the first storage pod (111), and
- lowering, in the vertical direction (V), the second storage pod (112) onto the third storage pod (113).

8. Method of storing a first storage pod (111) in a stack (110) comprising a plurality of storage pods (112, 113) stacked in a vertical direction (V) in a stocker system (100), wherein each storage pod (111, 112, 113) is adapted to hold one reticle (150) in its interior, comprises a base plate (115) and a cover (116), wherein alignment features (141, 142) configured and adapted to mechanically align adjacent storage pods (111, 112, 113) in the stack (110) are provided on the base plate (115) and the cover (116), and is provided with two handling members (120) arranged on opposite sides of the storage pod (111, 112, 113) in a first horizontal direction (H1), each of the handling members (120) is provided with a handling member engagement feature (121), and each of the storage pods (111, 112, 113) in the stack (110) is prevented from movement in a first horizontal direction (H1) by two holding structures (200), and in a second horizontal direction (H2) essentially perpendicular to the first horizontal direction (H1) by engagement of the handling member engagement features (121) with holding member engagement elements (211) provided on the holding structures (200), comprising the following steps:
- lifting, in the vertical direction (V), a second storage pod (112) arranged adjacent and vertically above a third storage pod (113) by a third distance, the third distance being greater than a sum of the height of the first storage pod (111) and a distance at least equal to the height, in the vertical direction (V), necessary to disengage the handling member engagement feature (121) of the first storage pod (111) from the holding member engagement elements (211) and the alignment features (141, 142) of the first storage pod (111) and the third storage pod (113),
- inserting, in the second horizontal direction (H2), the first storage pod (111) into a gap formed between the second storage pod (112) and the third storage pod (113),
- lowering, in the vertical direction (V), the first storage pod (111) onto the third storage pod (113), and
- lowering, in the vertical direction (V), the second storage pod (112) onto the first storage pod (111).

9. Device for retrieving a first storage pod (111) from and storing a first storage pod (111) in a stack (110) comprising a plurality of storage pods (111, 112, 113) stacked in a vertical direction (V) in a stocker system (100), each storage pod (111, 112, 113) being adapted to hold one reticle (150) in its interior, comprising a base plate (115) and a cover (116), wherein alignment features (141, 142) configured and adapted to mechanically align adjacent storage pods (111, 112, 113) in the stack (110) are provided on the base plate (115) and the cover (116), and being provided with two handling members (120) arranged on opposite sides of the storage pod (111, 112, 113) in a first horizontal direction (H1) and each of the handling members (120) being provided with a handling member engagement feature (121) and being prevented from movement in a first horizontal direction (H1) by two holding structures (200), and in a second horizontal direction (H2) essentially perpendicular to the first horizontal direction (H1) by engagement of the handling member engagement features (121) with holding member engagement elements (211) provided on the holding structures (200), comprising
- a first handling element for handling the first storage pod (111), and a second handling element adapted to handle a second storage pod (112), the first storage pod (111) being arranged or inserted adjacent and vertically below the second storage pod (112) within the stack (110) of storage pods (111, 112, 113), wherein the first handling element and the second handling element are adapted to be individually displaceable in a second horizontal direction (H2) and jointly or individually displaceable in a vertical direction (V) such that the second storage pod (112) can be lifted off or lowered onto the first storage pod (111) and the first storage pod (111) can be lifted off or lowered onto a third storage pod (113), the first storage pod (111) being arranged or inserted adjacent and vertically above the third storage pod (113) within the stack (110) of storage pods (111, 112, 113), the first storage pod (111) can be retrieved form or inserted into the stack (110) of storage pods (111, 112, 113), and the second storage pod (112) can be placed on or lifted of the third storage pod (113), the device being configured to perform the method of any of claims 7 and/or 8.

10. Method of retrieving a reticle (150) from a first storage pod (111) in a stack (110) comprising a plurality of storage pods (111, 112, 113) stacked in a vertical direction (V) in a stocker system (100), wherein each storage pod (111, 112, 113) is adapted to hold one reticle (150) in its interior, comprises a base plate (115) and a cover (116), wherein alignment features (141, 142) configured and adapted to mechanically align adjacent storage pods (111, 112, 113) in the stack (110) are provided on the base plate (115) and the cover (116), and is provided with two handling members (120) arranged on opposite sides of the storage pod (111, 112, 113) in a first horizontal direction (H1), each of the handling members (120) is provided with a handling member engagement feature (121), and each oaf the storage pods (111, 112, 113) is prevented from movement in a first horizontal direction (H1) by two holding structures (200), and in a second horizontal direction (H2) essentially perpendicular to the first horizontal direction (H1) by engagement of the handling member engagement features (121) with holding member engagement elements (211) provided on the holding structures (200), comprising the following steps:
- lifting, in the vertical direction (V), the cover (116) of the first storage pod (111) by a fourth distance (V4), the fourth distance (V4) being greater than a height of the reticle (150),
- lifting, in the vertical direction (V), the reticle (150) by a fifth distance (V5), the fifth distance (V5) being at least equal to the height, in the vertical direction (V), necessary to disengage the reticle (150) from the base plate (115),
- retracting, in the second horizontal direction (H2), the reticle (150) from the first storage pod (111), and
- lowering, in the vertical direction (V), the cover (116) of the first storage pod (111) onto the base plate (115) of the first storage pod (111).

11. Method of storing a reticle (150) in a first storage pod (111) in a stack (110) comprising a plurality of storage pods (111, 112, 113) stacked in a vertical direction (V) in a stocker system (100), wherein each storage pod (111, 112, 113) is adapted to hold one reticle (150) in its interior, comprises a base plate (115) and a cover (116), wherein alignment features (141, 142) configured and adapted to mechanically align adjacent storage pods (111, 112, 113) in the stack (110) are provided on the base plate (115) and the cover (116), and is provided with two handling members (120) arranged on opposite sides of the storage pod (111, 112, 113) in a first horizontal direction (H1), each of the handling members (120) is provided with a handling member engagement feature (121), and each of the storage pods (111, 112, 113) in the stack (110) is prevented from movement in a first horizontal direction (H1) by two holding structures (200), and in a second horizontal direction (H2) essentially perpendicular to the first horizontal direction (H1) by engagement of the handling member engagement features (121) with holding member engagement elements (211) provided on the holding structures (200), comprising the following steps:
- lifting, in the vertical direction (V), the cover (116) off the first storage pod (111) by a sixth distance, the sixth distance being greater than a height of the reticle (150),
- placing, in the vertical direction (V), the reticle (150) onto the base plate (115) of the first storage pod (111), and
- lowering, in the vertical direction (V), the cover (116) onto the base plate (115) of the first storage pod (111).

12. Device for retrieving a reticle (150) from a first storage pod (111) and placing the reticle (150) into a first storage pod (111) in a stack (110) comprising a plurality of storage pods (111, 112, 113) stacked in a vertical direction (V) in a stocker system (100), each storage pod (111, 112, 113) adapted to hold one reticle (150) in its interior, comprising a base plate (115) and a cover (116), wherein alignment features (141, 142) configured and adapted to mechanically align adjacent storage pods (111, 112, 113) in the stack (110) are provided on the base plate (115) and the cover (116), and being provided with two handling members (120) arranged on opposite sides of the storage pod (111, 112, 113) in a first horizontal direction (H1) and each of the handling members (120) being provided with a handling member engagement feature (121) and being prevented from movement in a first horizontal direction (H1) by two holding structures (200), and in a second horizontal direction (H2) essentially perpendicular to the first horizontal direction (H1) by engagement of the handling member engagement features (121) with holding member engagement elements (211) provided on the holding structures (200), comprising
- a third handling element for handling the cover (116) of the first storage pod (111), and a fourth handling element adapted to handle the reticle (150), the reticle (150) being arranged or to be placed in the first storage pod (111), wherein the third handling element and the fourth handling element are adapted to be individually displaceable in the second horizontal direction (H2) and jointly or individually displaceable in the vertical direction (V) such that the cover (116) of the first storage pod (111) can be lifted off the base plate (115) of the first storage pod (111) and the reticle (150) can be lifted off the base plate (115) of the first storage pod (111) or placed onto the base plate (115) of the first storage pod (111), the reticle (150) can be retrieved from or placed into the first storage pod (111) of the stack (110) of storage pods (111, 112, 113), and the cover (116) of the first storage pod (111) can be placed back on the base plate (115) of the first storage pod (111),
the device being configured to perform the method of any of claims 10 and/or 11.
